# EUROPEAN PATENT APPLICATION

(11) **EP 2 136 522 A1**
(43) Date of publication of application: **23.12.2009**
(21) Application number: 08104493.5
(22) Date of filing: 20.06.2008
(51) Int. Cl.: H04L 27/26, H03G 3/00

(54) **Method and device for data processing, communication system comprising such device, transmitter and receiver**

(71) Applicant: Nokia Siemens Networks Oy, 02610 Espoo (FI)
(72) Inventor: Thomas Hausten, 14469 Potsdam (DE); Dr. Werner Kozek, 1220 Wien (AT); Michael Siegert, 85570 Markt Schwaben (DE); Wolfgang Zirwas, 81249 München (DE)
(74) Representative: Bruglachner, Thomas E.

(57) **Abstract**

A method and a device for data processing are provided comprising the steps of (i) a transmitter conveys at least one adaptation signal to a receiver; and (ii) the receiver adjusts at least one parameter based on the at least one adaptation signal. Further, a communication system comprising such a device and a receiver as well as a transmitter are suggested.

## Description

The invention relates to a method and to a device for data processing, to a communication system comprising such a device and to a transmitter as well as to a receiver.

DSL or xDSL, is a family of technologies that provide digital data transmission over the wires of a local telephone network.

Asymmetric Digital Subscriber Line (ADSL) is a form of DSL, a data communications technology that enables faster data transmission over copper telephone lines than a conventional voice band modem can provide. Such fast transmission is achieved by utilizing frequencies that are normally not used by a voice telephone call, in particular, frequencies higher than normal human hearing.

VDSL (Very High Speed DSL) is an xDSL technology providing faster data transmission over a single twisted pair of wires. High bit rates are achieved at a range of about 300 meters (1000 ft), which allows for 26 Mbit/s with symmetric access or up to 52 Mbit/s in downstream - 12 Mbit/s in upstream with asymmetric access.

Currently, standard VDSL uses up to 4 different frequency bands, two for upstream (from the client to the telecom provider) and two for downstream. Suitable modulation techniques are QAM (quadrature amplitude modulation) or DMT (discrete multitone modulation).

According to its high bandwidth, VDSL is capable of supporting applications like HDTV, as well as telephone services (e.g., Voice over IP) and general Internet access, over a single connection.

VDSL2 (Very High Speed Digital Subscriber Line 2) is an access technology that exploits the existing infrastructure of copper wires that were originally used for plain old telephone service (POTS). It can be deployed from central offices (COs), from fiber-fed cabinets preferably located near the customer premises, or within buildings.

ITU-T G.993.2 (VDSL2) is an enhancement to G.993.1 (VDSL) that permits the transmission of asymmetric and symmetric (full duplex) aggregate data rates up to 200 Mbit/s on twisted pairs using a bandwidth up to 30 MHz.

The xDSL wide band modulation approaches are susceptible regarding crosstalk interference that is introduced to the twisted pair transmission line and received by the modem.

Crosstalk occurs when wires are coupled, in particular between wire pairs of the same or a nearby bundle that are used for different signal transmission. Hence, data signals from one or more sources can be superimposed on and contaminate a data signal. The crosstalk comprises a near-end crosstalk (NEXT) and a far-end crosstalk (FEXT).

Based on such crosstalk, data signals transmitted over twisted-pair lines can be considerably degraded by the crosstalk interference generated on one or more adjacent twisted-pair phone line in the same and/or a nearby multi-core cable or bundle. With an increasing transmission speed, this situation even deteriorates, which may significantly limit a maximum data rate to be transmitted via a single line.

Furthermore, idle data sent induce crosstalk interference and hence disturb user data sent via other lines of, e.g., a multi-core cable. As there are typically 50 lines within one multi-core cable, such crosstalk could significantly impair the overall performance of the transmitting capability.

Regarding ADSL or VDSL systems there is an attempt to improve an overall capacity or coverage for VDSL systems by utilizing a suitable precoding mechanism, e.g., by a matrix multiplication processed at the transmitting side. As typical VDSL systems support up to 50 customer premises equipments (CPEs) over one single cable the full crosstalk channel matrix is of size 50x50, which leads to a significant processing effort.

Fortunately, the far end crosstalk (FEXT) between the lines of the cable is often rather small thus leading to a sparsely occupied crosstalk matrix. Typically, the crosstalk matrix has basically a block diagonal structure that stems from the fact that the cable is separated into sub-bundles with high crosstalk, while the crosstalk of the sub-bundles is reduced due to a special drilling of said sub-bundles.

Precoding techniques like zero-forcing or MMSE estimation are known and may be utilized to at least partially compensate the crosstalk.

DSL layer 3 involves in particular the following challenges:
a) Processing of the precoding matrix at the central office (CO) may require processing a 50x50 precoding matrix, which results in a significant area on the chip and hence high power consumption. Hence, for systems to be practicable, useful solutions are required resulting in high performance gains at a moderate processing effort.
b) Up to 100 lines (50 lines in and 50 lines out) are attached to the precoding processing unit.
c) Ideally, almost no or only minimal changes to the current ADSL standard would be helpful for a new solution to remain (at least partially) compatible with existing equipment.
d) Estimation of all frequency selective cable channels and especially of crosstalk from each input to each output line with high accuracy and low protocol overhead would be required.

In addition, an automatic gain control (AGC) mechanism and/or algorithm may be provided with or run at the CPE and/or the DSLAM receivers. Automatic gain control is typically used for adapting the receive power to compensate power variations due to varying cable lengths. Such adjustment of the receiving power allows optimizing the signal input to the baseband processing unit prior to signal processing of the analog-to-digital converters (ADCs). As a control signal for adjusting the AGC a mean receive power measured over several or all sub-carriers of the multi carrier (MC) signal as well as over several symbols is utilized. This mean power value obtained is quite applicable and stable for real signals as well as for random signals received.

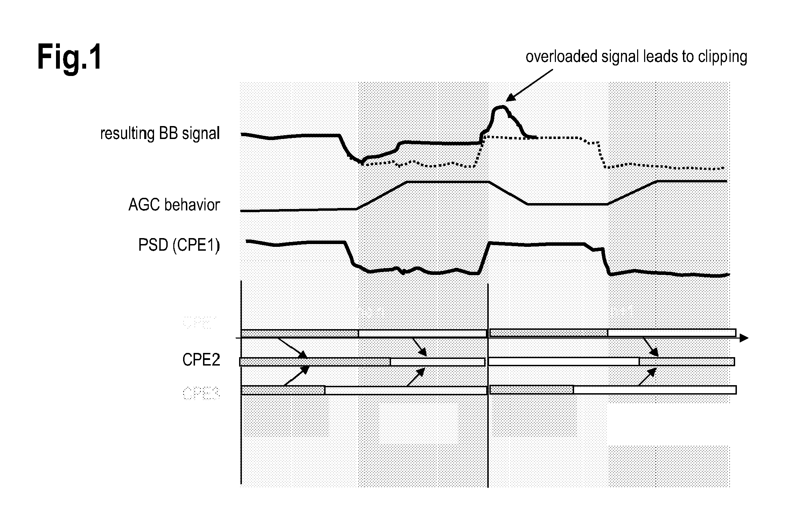

However, in case of a lasting time period of low power, the AGC at the receiver adapts to such low power signal and increases the amplification at the receiver. Such scenario is not detrimental in case the system maintains the low power mode, it may however become fatal in case the system switches back to normal transmission mode as the amplification then may be too high and clipping of the signal may occur. **Fig.1** visualizes such a scenario: CPE1 to CPE3 transmit user and idle data in a frame n and user data and idle data in a frame n+1. Pursuant to the distribution of user data and idle data in a frame, a power spectral density (PSD) for CPE1 is visualized. Based on such PSD the amplifier at the receiver, e.g., at CPE1 may adjust its AGC by increasing the amplification. As shown in the graph of the resulting baseband signal the user data received at the beginning of frame n+1 lead to an overamplification which may further result in clipping errors.

The **problem** to be solved is to overcome the disadvantages pointed out above and in particular to avoid clipping in case that the transmission switches back from low power mode to regular data transmission.

This problem is solved according to the features of the independent claims. Further embodiments result from the depending claims.

In order to overcome this problem, a method for data processing is provided comprising the steps:
- a transmitter conveys at least one adaptation signal to a receiver;
- the receiver adjusts at least one parameter based on the at least one adaptation signal.

According to an embodiment, the receiver adjusts its gain, in particular its gain control, based on said at least one adaptation signal such that subsequent user data are received substantially without error, in particular without clipping.

Hence, the at least one adaptation signal is efficiently utilized to adjust the receiver's gain control, in particular a power of at least one amplifier at the receiver, to substantially avoid a clipping effect or any other kind of overamplification at the receiver.

There may be various adaptation signals and/or control strategies applicable to achieve such a result.

This approach is in particular of advantage if crosstalk and/or interference is/are reduced by transmitting special data as (low-power) idle data. Such special data may comprise QAM constellation signals with low power for several or all sub-carriers, i.e. signal constellation points near the zero point, so that the power spectral density (PSD) of the transmitted signal is small and thus leads to almost no crosstalk.

In an embodiment, the at least one adaptation signal comprises intermittent signals in a low power mode and/or intermittent signals in a high power mode.

Advantageously, this approach avoids the AGC from increasing its amplification because of short low power mode intervals. Preferably, the duration of such interval is set receiver specific, in particular vendor and/or CPE specific.

In another embodiment, the at least one adaptation signal comprises a training signal that is transmitted in advance to user data transmission, said training signal enabling the receiver to enter a normal mode of operation.

Advantageously, a time for the training signal to be provided may depend on the receiver-specific configuration (delay needed to re-enter normal mode of operation). Such delay may be determined by means of probing, e.g., the transmitter sending probing signals to the receiver and adjusting the delay based on the response signals of the receiver, in particular via a feedback channel.

In a further embodiment, the at least one adaptation signal comprises a training signal of high power.

Such a burst of impulse signal can be used by the AGC to adapt faster to data sent at a normal mode and hence to efficiently avoid or significantly reduce clipping errors.

In a next embodiment, the at least one adaptation signal indicates a stepwise increase of transmission power.

Thus, based on the adaptation signal, the ACG may return to full or normal power mode by gradually increasing the amplification.

It is also an embodiment that no low power mode is entered in case no suitable strategy is found by means of testing and/or probing.

It is also an approach to check whether at least one of the strategies described may be applicable. If it is decided that no such strategy is suitable, the low power mode may not be entered. One example for such a decision is a more or less permanent transmission of user data such that there would be no significant energy saving effect by entering a short-term low-power idle mode.

It may be an option to iteratively apply test cycles and/or probing to find a promising strategy of (temporally) entering a low power idle mode. If no such thing is found, the receiver may remain in normal operation mode.

It is noted that normal operation mode may in particular differ from the low-power idle mode. In normal mode, no particular power-saving mechanism may apply, the transmitter sends idle-data without applying, e.g., constellation signals of low PSD. While normal operation suits well for user data to be conveyed, it may at least partially be detrimental if no user data are transmitted, because then normal mode of operation merely causes crosstalk and interference and consumes energy.

Pursuant to another embodiment, user data are utilized as said at least one adaptation signal.

Hence, errors due to clipping may be corrected at the receiver. This may be a feasible solution for quickly recovering receivers, i.e. receivers that are quickly adjusting to different receive power levels.

According to an embodiment, the at least one adaptation signal comprises or is associated with a pilot signal.

Such pilot channel may be utilized for AGC modification and/or setting purposes.

According to another embodiment, the at least one adaptation signal may be applied differently for each receiver.

It is also an embodiment that the transmitter conveys a next adaptation signal in case it receives a failure notification or no confirmation from the receiver. The failure notification may in particular comprise a negative acknowledgement (NACK) message.

It is noted that also no message provided by the receiver may indicate to the transmitter that the strategy based on the adaptation signal conveyed has not been successful. This can be determined by a time-out, i.e. in case a timer indicates that no confirmation or acknowledgement has been provided by the receiver to the transmitter within a given period of time.

According to that approach, the transmitter may process and/or try several strategies of adaptation signals to be conveyed to the receiver until a particular one provides the desired result (of no or little clipping errors).

One particular strategy may be to avoid entering any power-saving mode at the receiver by sending dummy data at a regular time basis. In such case, the gain control at the receiver is also adjusted, i.e. by not significantly increasing an amplification.

It is further noted that a particular (e.g., pre-set) amount of clipping errors or NACK messages may be acceptable at the transmitter before switching to another strategy, i.e. before applying different adaptation signals to be conveyed to the receiver.

In yet another embodiment, the method suggested is processed during a power-up phase and/or during a measurement phase.

According to a next embodiment, such method is processed during normal operation.

This may in particular apply for conveying user data, i.e. in case (also) user data are conveyed between transmitter and receiver.

Pursuant to yet an embodiment, constellation signals of low power are transmitted in case of no user data are conveyed from the transmitter to the receiver.

Such constellation signals may be particular QAM constellations of a low or reduced amplitude.

According to another embodiment, the transmitter and the receiver are connected via a digital subscriber line (DSL).

It is noted that all kinds of existing as well as future digital subscriber line may be applicable, e.g., ADSL, ADSL2, ADSL2+, VDSL, VDSL2, etc.

According to yet an embodiment, several connections between transmitters and receivers are merged into a cable binder.

It is also an embodiment that the transmitter and/or the receiver is or is associated with a Central Office or a Digital Subscriber Line Access Multiplexer. The transmitter and/or the receiver may be associated with a customer-premises equipment (CPE).

The problem stated above is also solved by a device comprising a and/or associated with a processor unit and/or a hard-wired circuit and/or a logic device that is arranged such that the method as described herein is executable on said processor unit.

According to an embodiment, the device said device is or is associated with a communication device, in particular a Central Office, a Digital Subscriber Line Access Multiplexer or a customer premises equipment.

The problem stated supra is further solved by a communication system comprising the device as described herein.

The problem is also solved by a receiver comprising means for receiving at least one adaptation signal and means for adjusting the receiver's gain control based on the at least one adaptation signal such that subsequent user data are received substantially without clipping.

The problem described above is further solved by a transmitter comprising means for selecting at least one adaptation signal to be conveyed to a receiver, in particular to the receiver of claim 22, that allows the receiver to adjust a gain control based on the at least one adaptation signal such that subsequent user data are received substantially without clipping.

According to an embodiment, several adaptation signals are conveyed to the receiver until substantially no errors or only a limited number of errors are reported by the receiver.

Embodiments of the invention are shown and illustrated in the following figure:

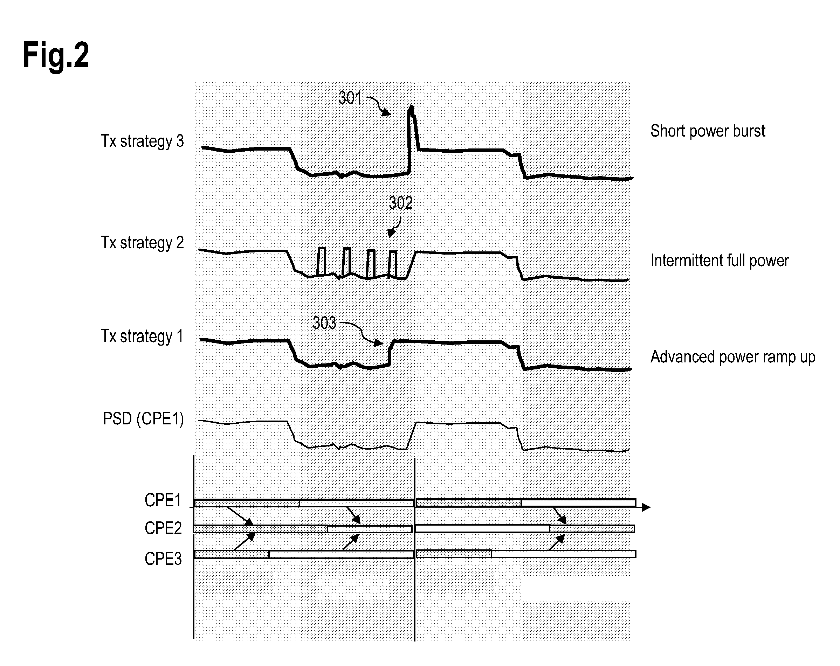

Fig.2 shows various strategies to avoid clipping errors at a receiver associated in particular with a digital subscriber line.

The approach suggested allows handling an automatic gain control (AGC), in particular coping with an AGC behavior.

An AGC probing mechanism is applied, e.g., at power up or during particular measurement phases. Hence, a transmission (Tx) signal can be switched from a low and/or a no power mode to full power transmission. If valid and known signals are transmitted, an automatic repeat request acknowledgement /not acknowledgement messages (ARQ ACK/NACK) messages or any other useful feedback can be used to check how long it takes before the modem has adapted its AGC and is back in a suitable receive (Rx) mode substantially without clipping errors.

Another training test would be for the transmitter to send data (e.g., test data) at a normal transmission power and check for a time period as how long a low power mode could be applied without significant changes applied to AGC settings. In other words, the transmitter switches to low power mode for such period of time then re-enters the normal (full) power mode: As the time period of the low power mode is sufficiently short, the AGC may not change and the full power mode can be re-entered any time without a significant risk of clipping. Therefore, it could be a transmission strategy to intermittently transmit n frames in low power mode and for the purpose of keeping the AGC in normal mode m frames with high power. Values for n and m may in particular be vendor and/or CPE specific.

Other training strategies may be applicable, resulting in different low power mode transmission strategies for each CPE. The DSLAM may store different (in particular all) transmission strategies for various (in particular for all) active CPEs in a memory or database and uses the respective strategy whenever a CPE is switched into a pseudo idle low power mode.

The following control strategies of handling and/or initiating said low power mode may apply. In particular, combinations thereof may be applicable:
a. Advanced Power-Up:
   An AGC training signal is sent in advance to real (user) data transmission. The time for the training signal to be sent in advance may be adapted depending on the outcome of the CPE specific probing or it may depend on vendor information for this CPE.
b. Short power burst:
   To minimize the training phase it might be useful to send the AGC training signal with higher power so that the AGC may adapt faster.
c. Gradually increase of transmission power:
   The transmission power can be reduced after idle mode to lower power and afterwards it can be increased stepwise until full power is reached.
   Such approach may increase an error probability due to the low receive power. Hence, an advantageous range of a transmission power level is required over time CPE/vendor specific so that bit errors due to clipping as well as due to said low receive power are similar.
d. Intermittently sent high power information:
   A maximum of n frames and/or symbols are sent in low power mode and intermittently at least m frames and/or symbols are sent in high power mode. If n and m is chosen appropriately per vendor and/or per CPE the AGC may be kept from adopting its setting to the lower receive power.
   A time period of low power mode may depend on the timing constants of the AGC. As the line length is fixed and for ADSL changes are quite slow it can be assumed that AGC setting changes rather on a long term basis. In that case this approach may be a preferred option.
e. Avoid low-power idle mode:
   If there is no suitable low power idle mode strategy found during probing, a strategy can be to not enter the low power idle mode at all.
f. Instead of sending a training signal prior to sending user data, another approach may be to accept clipping errors and to correct such errors by ARQ or HARQ mechanisms. This may be a suitable strategy for CPEs that recover or adapt fast to new receive power levels and which have a high back off and therefore produce only a small number of clipping errors.
g. Advantageously, an AGC behavior can be configured as a future standard release that avoids clipping, e.g., by checking a power of pilot signals before adapting its AGC value. Alternatively, the AGC should be able to deal with longer drops in signal power.

**Fig.2** shows various strategies to avoid clipping errors at a receiver associated in particular with a digital subscriber line. CPE1 to CPE3 are merged in one physical cable binder which may inflict crosstalk and/or interference. The single transmitters at a CO may distribute portions of user data and idle data within a frame arbitrarily or in order to reduce said crosstalk and/or interference. In any case, there may be time periods when user data is conveyed and time periods when idle data is transmitted.

Said idle data may in particular utilize constellations of low spectral density in order to reduce an amount of energy required during idle periods.

In such scenario, the idle data may be automatically amplified at a AGC of the receiver (due to its lower signal-to-noise ratio compared to the user data). As described above, such high amplification may result in clipping errors as soon as user data are received at full power (see, e.g., CPE1 after the idle data period of frame n is over and the user data of frame n+1 are received).

The approach suggested herewith allows an efficient handling of such case and in particular to avoid or at least significantly reduce clipping errors. Several approaches are shown as transmission strategies "Tx strategy" in Fig.2.

Tx strategy 1 corresponds to the scenario described under a. above. The power ramp 303 is set well before the user data of frame n+1 are received.

Tx strategy 2 corresponds to the scenario described under d. above. Intermittently, full power busts 302 are transmitted in order to avoid the AGC at the receiver to increase the receiver's amplification.

Tx strategy 3 corresponds to the scenario described under b. above. The power bursts 301 allows a fast adaptation of the AGC (in particular of the amplification), which is preferably set with the first arriving user data of frame n+1.

The proposed solution allows transmitting at a reduced power for VDSL standard conform CPEs. It efficiently solves the issue of AGC clipping.

In standardization specific AGC relevant messages may be defined to enable an efficient probing of the AGC behavior during training. Such messages may be fast ACK/NACK messages or feedback of actual bit error rates (BERs).

### Abbreviations:

- ACK: acknowledge
- ADC: analog-to-digital converter
- AGC: automatic gain control
- ARQ: automatic repeat-query (or query)
- CO: central office
- CPE: customer premises equipment
- DL: downlink
- DSL: digital subscriber line
- DSLAM: digital subscriber line access multiplexer
- HARQ: hybrid automatic repeat request
- MC: multi carrier
- MS: mobile station
- MMSE: minimum mean square error estimation
- NACK: not acknowledge
- PSD: power spectral density
- SC: sub-carrier
- ZF: zero forcing

## Claims

1. A method for data processing comprising the steps:
- a transmitter conveys at least one adaptation signal to a receiver;
- the receiver adjusts at least one parameter based on the at least one adaptation signal.

2. The method according to claim 1, wherein the receiver adjusts its gain, in particular its gain control, based on said at least one adaptation signal such that subsequent user data are received substantially without error, in particular without clipping.

3. The method according to any of the preceding claims, wherein the at least one adaptation signal comprises intermittent signals in a low power mode and/or intermittent signals in a high power mode.

4. The method according to any of the preceding claims, wherein the at least one adaptation signal comprises a training signal that is transmitted in advance to user data transmission, said training signal enabling the receiver to enter a normal mode of operation.

5. The method according to any of the preceding claims, wherein the at least one adaptation signal comprises a training signal of high power.

6. The method according to any of the preceding claims, wherein the at least one adaptation signal indicates a stepwise increase of transmission power.

7. The method according to any of the preceding claims, wherein no low power mode is entered in case no suitable strategy is found by means of testing and/or probing.

8. The method according to any of the preceding claims, wherein user data are utilized as said at least one adaptation signal.

9. The method according to any of the preceding claims, wherein the at least one adaptation signal comprises or is associated with a pilot signal.

10. The method according to any of the preceding claims, wherein the at least one adaptation signal may be applied differently for each receiver.

11. The method according to any of the preceding claims, wherein the transmitter conveys a next adaptation signal in case it receives a failure notification or no confirmation from the receiver.

12. The method according to claim 11, wherein said failure notification comprises a negative acknowledgement message.

13. The method according to any of the preceding claims, wherein the method is processed during a power-up phase and/or during a measurement phase.

14. The method according to any of the preceding claims, wherein such method is processed during normal operation.

15. The method according to any of the preceding claims, wherein constellation signals of low power are transmitted in case of no user data are conveyed from the transmitter to the receiver.

16. The method according to any of the preceding claims, wherein the transmitter and the receiver are connected via a digital subscriber line.

17. The method according to any of the preceding claims, wherein several connections between transmitters and receivers are merged into a cable binder.

18. The method according to any of the preceding claims, wherein the transmitter and/or the receiver is or is associated with a Central Office or a Digital Subscriber Line Access Multiplexer.

19. The method according to any of the preceding claims, wherein the transmitter and/or the receiver is or is associated with a customer-premises equipment.

20. A device comprising a and/or associated with a processor unit and/or a hard-wired circuit and/or a logic device that is arranged such that the method according to any of the preceding claims is executable thereon.

21. The device according to claim 20, wherein said device is or is associated with a communication device, in particular a Central Office, a Digital Subscriber Line Access Multiplexer or a customer premises equipment.

22. Communication system comprising the device according to any of claims 20 or 21.

23. A receiver comprising means for receiving at least one adaptation signal and means for adjusting the receiver's gain control based on the at least one adaptation signal such that subsequent user data are received substantially without clipping.

24. A transmitter comprising means for selecting at least one adaptation signal to be conveyed to a receiver, in particular to the receiver of claim 23, that allows the receiver to adjust a gain control based on the at least one adaptation signal such that subsequent user data are received substantially without clipping.

25. The transmitter according to claim 24, wherein several adaptation signals are conveyed to the receiver until substantially no errors or only a limited number of errors are reported by the receiver.
